(19) Europäisches Patentamt

European Patent Office

Office européen des brevets

(11) **EP 1 355 427 B1**

(12) **EUROPEAN PATENT SPECIFICATION**

(45) Date of publication and mention
of the grant of the patent:
**06.12.2006 Bulletin 2006/49**

(51) Int Cl.:
***H03M 1/12*** *(2006.01)*

(21) Application number: **03101033.3**

(22) Date of filing: **16.04.2003**

(54) **Differential comparator circuit**

Differential-Komparatorschaltung

Circuit comparateur différentiel

(84) Designated Contracting States:
**AT BE BG CH CY CZ DE DK EE ES FI FR GB GR
HU IE IT LI LU MC NL PT RO SE SI SK TR**

(30) Priority: **19.04.2002 FI 20020763**

(43) Date of publication of application:
**22.10.2003 Bulletin 2003/43**

(73) Proprietor: **Micro Analog Systems OY
02770 Espoo (FI)**

(72) Inventor: **Sillanpää, Tero
00800, Helsinki (FI)**

(74) Representative: **Äkräs, Tapio Juhani
Kolster Oy Ab,
Iso Roobertinkatu 23,
P.O. Box 148
00120 Helsinki (FI)**

(56) References cited:
**EP-A- 0 349 954          US-A- 5 488 321
US-A- 5 621 340          US-A- 5 973 561
US-A- 6 160 424**

**Description**

**Field of the invention**

The present invention relates to the field of electronic circuits and, more particularly, to a comparator circuit.

**Background of the invention**

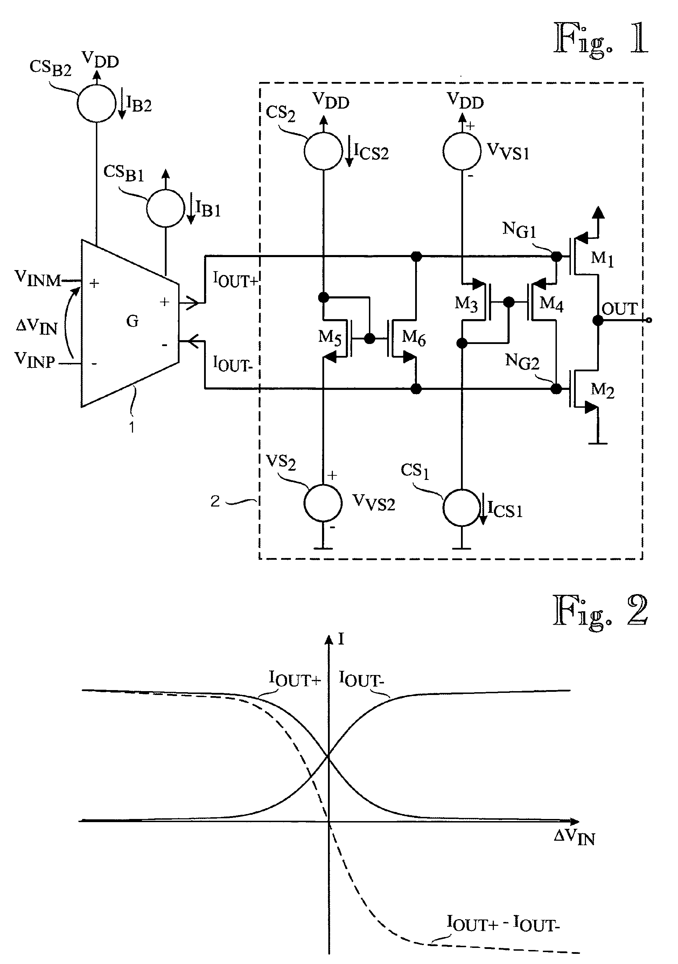

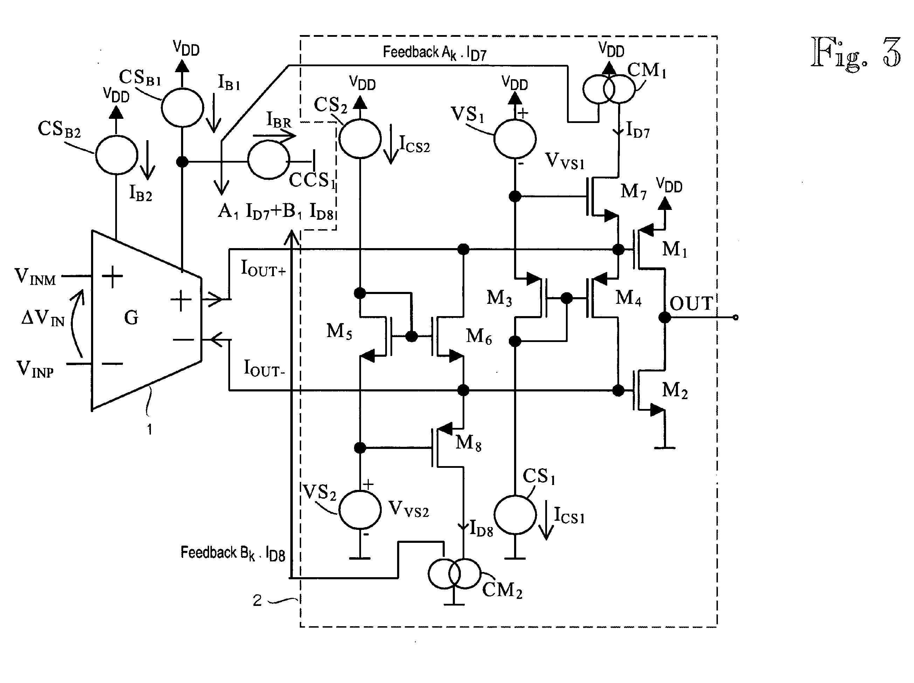

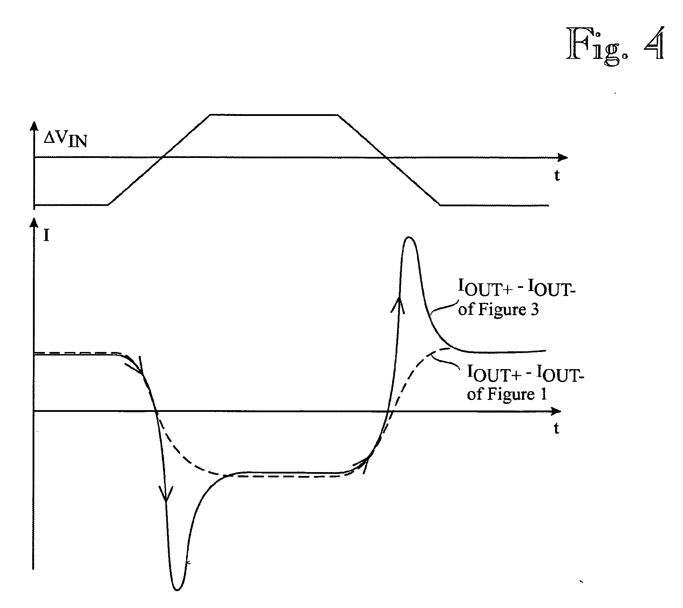

Comparators are widely used in variety of electronic devices for comparing input signals or voltages and providing an output signal representing the result of the comparison. One type of comparator includes a differential input stage having a pair of inputs for receiving a differential input voltage (i.e. the voltages to be compared) and an output stage capable to deliver a large current to a load. An example of such comparator is illustrated in a simplified schematic diagram shown in Figure 1. The comparator includes a differential transconductance input stage 1 which converts a differential input voltage $\Delta V_{IN}$ to differential output currents $I_{OUT+}$ and $I_{OUT-}$. When the input voltages $V_{INM}$ and $V_{INP}$ are at the same potential, i.e. in balance, the differential voltage $\Delta V_{IN}$ is zero and the output currents $I_{OUT+}$ and $I_{OUT-}$ are equal. When the inputs $V_{INM}$ and $V_{INP}$ are not in balance, the output currents of the differential transconductance stage 1 will differ from each other. The output currents $I_{OUT+}$ and $I_{OUT-}$ are applied to a transistor output stage which is capable to deliver large current to a load at the output OUT when the output is switching. In the illustrated example a CMOS (Complementary Metal On Silicon) transistor-coupled rail-to-rail class-AB output stage. The main output transistors are $M_1$ and $M_2$. The output transistor $M_1$ is biased by a voltage source $VS_1$, a current source $CS_1$, and the transistors $M_3$ and $M_4$. Similarly, output transistor $M_2$ is biased by a voltage source $VS_2$, a current source $CS_2$, and the transistors $M_5$ and $M_6$. The operation and structure of the illustrated comparator will be analysed in more detail below. The inventor has observed that, for the reasons analysed in more detail below, the comparator response time is relatively high and therefore unsatisfactory for many applications.

EP 0349954 discloses differential to a single ended converter circuit wherein voltage swing at a gate of an output transistor is limited to a small value in order to reduce the delay caused by charging and de-charging of a parasitic capacitance at the gate. US 5488321 discloses a high speed comparator wherein a voltage swing at an output of a transconductance stage, i.e. at an input of a transresistance> output stage, is limited.

**The summary of the invention**

An object of the invention is to decrease a response time of a comparator circuit.

This object is achieved by a comparator circuit according to the independent claim 1. Various embodiments of the invention are disclosed in the dependent claims.

The basic idea of the present invention is to limit a voltage swing at the internal node(s) of a transistor output stage in a comparator. The inventor has observed that the internal node voltages in a conventional transistor output stage of a comparator may swing almost over a full supply voltage range, which slows down the comparator response time and makes the response time dependent on the supply voltage. In accordance with the present invention, by limiting the voltage swing during transients within the transistor output stage the comparator response time can be reduced and made independent from the supply voltage.

In an embodiment of the invention biasing of a differential input stage is decreased when the voltage swing limiting is active in the transistor output stage. The output currents from the input stage charges and discharges capacitances at the internal node of the transistor output stage. The higher the output currents from the input stage are when the transistor output stage switches, the shorter is the time needed for charging and discharging the internal parasitic capacitances in the output stage, and the shorter is the comparator response time. On the other hand, when the output of the output stage has been switched and stabilized, the high output currents from the input stage are unnecessary and increase the current consumption of the comparator. As the voltage swing limiting according to the present invention becomes active when the transient or switching of the output stage is ending, the output currents can be decreased by decreasing the biasing of the input stage when the limiting is active. This decreases the current consumption when the switching has ended and the output has stabilized. On the other hand, when the voltage swing limiting according to the present invention is not active, the switching and transient is going on and the high output currents from the input stage are preferred, and therefore normal higher biasing can be allowed for the input stage. Thus, this further embodiment increases the speed of the comparator while offering low power consumption. A further advantage is that, because the biasing of the input stage is controlled based on the transient in the output stage, the zero-crossover speed of the differential input voltage does not affect significantly on the biasing. As a consequence, the comparator is insensitive to the input voltage step or speed of change.

These and other features, aspects and advantages of the present invention will become better understood with regards to the following description, appended claims, and accompanying drawings.

## Brief description of the drawings

Figure 1 is a schematic circuit diagram of a conventional comparator circuit,
Figure 2 is a graph illustrating the differential output current of the input stage in function of the differential input voltage,
Figure 3 is a schematic circuit diagram of a comparator circuit according to an embodiment of the present invention,
Figure 4 is a timing diagram illustrating the relationship between the differential input voltage and the differential output currents of the comparators shown in Figures 1 and 3.

## A detailed description of the invention

Let us first analyse the operation of the conventional comparator circuit shown in Figure 1. As already described above, the comparator of Figure 1 includes a differential transconductance input stage 1 and a transistor output stage 2 which is capable of delivering large current to the load when the output OUT of the comparator is switching, i.e. changing its stage between a first output level (e.g. supply voltage VDD) and a second output level (e.g. ground potential). In this example the output stage is a CMOS transistor-coupled rail-to-rail class-AB output stage. The main output transistors are the pnp-type CMOS transistor $M_1$ and the npn-type CMOS transistor $M_2$ which are operationally series connected between the supply voltage $V_{DD}$ and the ground. More particularly, the source of transistor $M_1$ is operationally connected to the $V_{DD}$, the gate is connected to receive the output current $I_{OUT+}$ from the input stage 1, and the drain is connected to an output OUT of the comparator. Similarly, the source of transistor $M_2$ is operationally connected to ground, the gate is connected to receive the output current $I_{OUT-}$ from the input stage 1, and the drain is connected to the drain of the $M_1$ and to the output OUT. The output transistor $M_1$ is biased by the voltage source $VS_1$, the current source $CS_1$ and the p-type CMOS transistors $M_3$ and $M_4$. More particularly, the transistor $M_4$ is connected between the gates of the transistors $M_1$ and $M_2$ so that the source of $M_4$ is connected to the gate of $M_1$ (the connection node is designated as $N_{G1}$ in Figure 1) and the drain of $M_4$ is connected to the gate of $M_2$ (the connection node is designated as $N_{G2}$ in Figure 1). The source of the transistor $M_3$ is connected to the negative terminal of the voltage source $V_{S1}$, the positive terminal of the $VS_1$ being connected to the supply voltage $V_{DD}$. The drain of $M_3$ is connected to one terminal of the current source $CS_1$, the other terminal of $CS_1$ being connected to ground. The gate of $M_3$ is connected to the gate of $M_4$ and to the drain of $M_3$. Similarly the output transistor $M_2$ is biased by the voltage source $VS_2$, the current source $CS_2$, and the n-type CMOS transistors $M_5$ and $M_6$. More particularly, the drain of transistor $M_6$ is connected to the gate of $M_1$ and the drain is connected to the gate of $M_2$. The source of the transistor $M_5$ is connected to the positive terminal of the voltage source $VS_2$, the negative terminal of the $VS_2$ being connected to ground. The drain of $M_5$ is connected to a first terminal of the current source $CS_2$, the second terminal of the $CS_2$ being connected to the supply voltage $V_{DD}$. The gate and drain of $M_5$ are interconnected, and the gate is further connected to the gate of $M_6$.

Let us now study the operation of the comparator circuit shown in Figure 1.

As noted above, the output transistor M1 is biased by the $VS_1$, $M_3$, $M_4$ and $CS_1$. The current source $CS_1$ sinks constant current through the transistor $M_3$ and the voltage source $VS_1$. Usually the current density through the transistor $M_4$ is designed to be same as through the transistor $M_3$, i.e.

$$\frac{I_{D4}}{I_{D3}} = \frac{W_4 / L_4}{W_3 / L_3},$$

which leads to the same gate source voltages Vgs3 and Vgs4. In the equation, the $W_i$ and $L_i$ denote the channel width and length of a transistor $M_i$. The gate-source voltage of $M_1$ will therefore bias to the voltage $V_{VS1}$ of the $VS_1$. The current $ID_1$ of the transistor $M_1$ is set approximately by equation

$$I_{D1} = \frac{1}{2} \cdot K_P \cdot \frac{W_1}{L_1} \cdot (V_{VS1} - V_{Tp})^2.$$

Often the voltage source $VS_1$ is diode-connected pmos transistor, which matches to the transistor $M_1$. The current $I_{D1}$ of the transistor $M_1$ will match to the current $I_{CS1}$ of the current source $CS_1$ by the equation

$$I_{D1} = \frac{W_1/L_1}{W_9/L_9} \cdot I_{CS1},$$

in which index 9 denotes to the $VS_1$ implemented by the diode-connected pmos transistor. The drain current $ID_1$ of $M_1$ is therefore adjustable by the W/L-ratios and the current $I_{CS1}$. In practice the voltage source $VS_1$ can be also some other circuit element. For example, also resistors, diode-connected bipolar transistors, diodes or some source/emitter follower with proper biasing giving proper voltage bias for the transistors $M_1$ and $M_2$ can be used for implementing the voltage sources $VS_1$ and $VS_2$.

Similarly, the transistor $M_2$ will bias to the voltage $V_{VS2}$ of the voltage source $VS_2$. The drain current $I_{D2}$ of the transistor $M_2$ will be adjustable by the voltage source $VS_2$ or by the current source $CS_2$.

The differential transconductance input stage 1 converts differential input voltage $\Delta V_{IN}$ to differential output currents $I_{OUT+}$ and $I_{OUT-}$. When inputs $V_{INM}$ and $V_{INP}$ are at the same potential, i.e. in balance, biasing currents of $I_{OUT+}$ and $I_{OUT-}$ are designed to be same. Further, the output currents $I_{OUT+}$ and $I_{OUT}$- are designed according

$$I_{OUT+} = I_{OUT-} = I_{S4} + I_{D6}.$$

Since

$$I_{S4} = \frac{W_4/L_4}{W_3/L_3} \cdot I_{S3} = \frac{W_4/L_4}{W_3/L_3} I_{CS1}$$

and

$$I_{D6} = \frac{W_6/L_6}{W_5/L_5} \cdot I_{D5} = \frac{W_6/L_6}{W_5/L_5} \cdot I_{CS2},$$

we get the design equation

$$I_{OUT+} = I_{OUT-} = \frac{W_4/L_4}{W_3/L_3} \cdot I_{CS1} + \frac{W_6/L_6}{W_5/L_6} I_{CS2}.$$

Further, if the currents $I_{D1}$ and $I_{S2}$ are designed to be equal, we have proper biasing for the comparator. Often W/L ratios of the transistors $M_3$, $M_4$ and $M_5$, $M_6$ and the bias currents $I_{CS1}$ and $I_{CS2}$ are designed to be same which leads to $I_{S4} = I_{D6} = 0.5\ I_{OUT+} = 0.5\ I_{OUT-}$.

When inputs $V_{INM}$ and $V_{INP}$ are not in balance, the output currents $I_{OUT+}$ and $I_{OUT-}$ of differential transconductance stage 1 will differ from each other. Let us assume that $V_{INP} > V_{INM}$. The output current $I_{OUT+}$ will be smaller than the output current $I_{OUT-}$. This leads to the situation that the transistor $M_6$ will adapt to the increased current since higher output current $I_{OUT-}$ pulls the source voltage of the transistor $M_6$ lower thereby increasing the drain current $I_{D6}$ through the transistor $M_6$. Since the output current $I_{OUT+}$ is decreasing and the drain current $I_{D6}$ is increasing, the current $I_{D4}$ of the transistor $M_4$ decreases. Finally, there is no current left for the transistor $M_4$ and the source voltage of the transistor $M_4$, i.e. node $N_{G1}$ voltage, will drop heavily. It drops until the transistor $M_6$ gets into linear region. In the linear region the transistor $M_6$ is not able to keep the source voltage $N_{G2}$ of the $M_6$ like it keeps it in saturation - the transistor $M_6$ starts to act like a resistor - and also the source voltage of the transistor $M_6$ drops toward ground voltage until the voltage of the node $N_{G2}$ gets too small for actual current source device of transconductance amplifier 1 and the device saturates. Since the voltages $N_{G1}$ and $N_{G2}$ drop close to ground voltage, the transistor $M_1$ turns completely on and the transistor $M_2$ turns completely off. This enables high output current in switching.

Opposite behavior is observed in opposite case. When $V_{INP} < VI_{NM}$, the node voltages $N_{G1}$ and $N_{G2}$ rises almost to the supply voltage $V_{DD}$.

A problem with this conventional output stage is that the voltages of nodes $N_{G1}$ and $N_{G2}$ swing almost over the full supply voltage. This slows down the comparator response time and makes the response time dependent on the supply voltage.

Another problem is that the differential output currents $I_{OUT+}$ - $I_{OUT-}$, which chargers or discharges the nodes $N_{G1}$ and $N_{G2}$, are usually set by one or more constant current sources $CS_B$ providing a bias current $I_B$ ($I_{B1}$ and $I_{B2}$ in Figure 1). For example, a typical bipolar differential input stage has output currents according

$$I_{OUT+} = \frac{M \cdot I_B}{1 + e^{\frac{\Delta V_{IN}}{V_T}}}$$

and

$$I_{OUT-} = \frac{M \cdot I_B}{1 + e^{\frac{-\Delta V_{IN}}{V_T}}}.$$

After some manipulation, the output current difference is

$$I_{OUT+} - I_{OUT-} = M \cdot I_B \cdot \tanh(\frac{\Delta V_{IN}}{2 \cdot V_T}).$$

Factor M is a multiplying factor of the bias current $I_B$. These waveforms of the output currents $I_{OUT+}$ and $I_{OUT-}$ as a function of input differential voltage are illustrated in Figure 2. The output differential current $I_{OUT+}$ - $I_{OUT-}$ is illustrated only in transient - in practice when the voltages of nodes $N_{G1}$ and $N_{G2}$ approach $V_{DD}$ or ground, the output currents $I_{OUT+}$ and $I_{OUT-}$ will drop close to zero because output current source of the transconductance stage 1 saturates. The internal bias currents in the transconductance stage 1 will continue to consume current.

As the differential input voltage $\Delta V_{IN}$ increases (or decreases) from 0V, the differential output current $I_{OUT+}$ - $I_{OUT-}$ saturates to a certain limit set by the bias current $M \cdot I_B$. If a designer wants to decrease the propagation delay further, at least one of the bias currents $I_B$ must be increased. This means higher current consumption. Another way to decrease the response time is to increase the output current $I_{OUT+}$ and $I_{OUT-}$ by introducing larger current mirroring at the output of the transconductance stage 1 (not shown in Figure 1). Since the output of this last current mirror saturates when the inputs $VI_{NM}$ and $V_{INP}$ are unbalanced, it does not increase current consumption. Unfortunately, this current mirror is on the signal path and larger current mirror introduces higher parasitic capacitances canceling partially or totally improvement.

Third problem related to this conventional structure is that if bipolar transistors are used at the output of transconductance stage 1, they will saturate. Increasing the collector voltage from saturation takes more time because the collector-base capacitance is bigger than in the linear range.

An example of a comparator according to the present invention is illustrated by a simplified schematic diagram shown in Figure 3. In this embodiment, a solution the above problems is to limit the voltage swing at sources of the transistors $M_4$ and $M_6$, and to boost at least one of the bias currents of the input stage 1 during the transient.

In Figure 3, the same parts are designated with the same symbols as in Figure 1. In the following only the differences will be described in more details. In the embodiment shown in Figure 3, new transistors $M_7$ and $M_8$ are introduced. The n-type CMOS transistor $M_7$ has a source connected to the gate of the transistor $M_1$, a gate connected to the negative terminal of the voltage source $VS_1$, and a drain connected through a current measurement element to the supply voltage $V_{DD}$. The p-type CMOS transistor M8 has a source connected to the gate of the transistor $M_2$, a gate connected to the positive terminal of the voltage source $VS_2$, and a drain connected through a current measurement element to the ground.

The transistors $M_7$ and $M_8$ limit the source voltages of the transistors $M_4$ and $M_6$, respectively. The drain current of the transistors $M_7$ and $M_8$ are monitored and fed back to the biasing circuit of the input stage in order to attenuate charging/discharging currents of node voltages $N_{G1}$ and $N_{G2}$. The monitoring and feedback is illustrated by a current source $CCS_1$ having a current $I_{BR}$ which is dependent of the drain currents $I_{D7}$ and $I_{D8}$ of the transistors $M_7$ and $M_8$. In an actual implementation, current mirrors $CM_1$ and $CM_2$ can be user for measuring the drain currents $I_{D7}$ and $I_{D8}$ of the transistors $M_7$ and $M_8$, respectively, and for subtracting the sum current $I_{BR} = A_1*I_{D7} + B_1*I_{D8}$ from $CS_{B1}$ bias current.

The $A_1$ and $B_1$ coefficients are set by design of the current mirrors. Also resistors with an amplifying element connected across the resistors can be used to detect or measure the drain currents $I_{D7}$ and $I_{D8}$ of the transistors $M_7$ and $M_8$.

Consider that the inputs $V_{INM}$ and $V_{INP}$ are in balance and the output OUT is at middle of the supply voltage $V_{DD}$ and ground. The source-gate voltage of the transistor $M_1$ is $V_{VS1}$. The gate-source voltage of the transistor $M_7$ is therefore zero and $M_7$ does not conduct any current. Similarly, the transistor $M_8$ is off. Since the currents $I_{D7}$ and $I_{D8}$ are 0 ampere, the controlled current source $CCS_1$ has a current of 0 amperes, and the transconductance stage 1 has same bias current as in Figure 1, namely $I_{B1}$ and $I_{B2}$. In other words, in balance the transistors $M_7$ and $M_8$ do not change the operation of the comparator.

Let us assume that the input $V_{INP}$ increases compared to the input $V_{INM}$. The output current $I_{OUT+}$ will decrease and the output current $I_{OUT-}$ will increase. In a similar manner as in Figure 1, the transistor $M_6$ will adapt to increased output current $I_{OUT-}$, and the source current of the transistor $M_4$ will decrease until it is zero. The source voltage of the transistor $M_4$ will decrease but not to the ground. The transistor $M_7$ will turn on and thereby limit the voltage swing at the source of the transistor $M_1$ to the gate-source voltage $V_{GS7}$ of the transistor $M_7$. Since the transistor $M_7$ is now conducting, one ore more bias currents of transconductance stage 1 will be affected, in other words these currents will decrease, since the current source $CCS_1$ shunts the current $I_{BR}$ to ground, and thereby only bias current $I_{BI}$-$I_{BR}$ is applied to the input stage 1. The amount of the decrement depends on the loop gain set by the transistor $M_7$ and the factor $A_{K1}$ or $B_{K1}$. The output currents $I_{OUT+}$ and $I_{OUT-}$ will drop until $I_{OUT-}$ equals to $I_{D7}$+$I_{OUT+}$. This will finally happen because the current $I_{D7}$ increases while the output currents $I_{OUT-}$ and $I_{OUT+}$ decrease, and the output current $I_{OUT+}$ is much smaller than the output current $I_{OUT-}$. $I_{OUT+}$ is finally neglible compared to $I_{OUT-}$. The output current $I_{OUT-}$ will settle below the bias current $I_{B1}/A_1$ because if the output current $I_{OUT-}$ would remain over the current $I_{B1}/A_1$, there would not be bias left for transconductance stage 1. The loop gain sets how much below the bias current $I_{B1}/A_1$ the output current $I_{OUT-}$ will settle.

The source voltage of the transistor $M_6$ will not drop to the ground voltage, if the supply voltage $V_{DD}$ is high enough to prevent the transistor $M_6$ to drop in linear range, i.e. if the source voltage of the transistor $M_7$ is well above the saturation limit of the transistor $M_6$. Therefore, the gate voltage of the transistor $M_2$ does not drop to zero, and the output transistors $M_1$ and $M_2$ will conduct some current even the comparator inputs $V_{INM}$ and $V_{INP}$ are not in balance. Therefore, the transistors $M_1$ and $M_2$ cannot be designed large in order to drive a large load capacitance. However, this drawback can be avoided by adding buffering inverter(s) to the output. The delay of the buffer inverters is anyway neglible compared to the delay from input to the nodes $N_{G1}$ and $N_{G2}$.

In the comparator of Figure 3, the current consumption of comparator when the inputs are in balance, is designed to be much higher than in the comparator of Figure 1. On the other hand, the current consumption of the comparator in Figure 3 when the inputs are not in balance, is designed to be the same or lower as the bias current in Figure 1 with the inputs in balance. The bias voltages $V_{VS1}$ and $V_{VS2}$ for the transistors $M_1$ and $M_2$ are designed to be lower or W/L-ratio of the transistors $M_1$ and $M_2$ are designed to be lower than in Figure 1, in order to keep currents of transistors $M_1$ and $M_2$ small. The comparator is in transient only for a short duration of time, i.e. the transistor $M_7$ or $M_8$ does not conduct. Therefore, the boosted bias current does not increase the average current consumption of the comparator significantly if transient time (boosted current duration) is significantly shorter than time period between comparisons. This is usual case. Let us consider a practical example. A comparator in Figure 1 without the voltage limiting and the current boosting according to the invention has a propagation delay of 15 $\mu$s from input to output. The delay was measured with 3.6V supply voltage $V_{DD}$, with current consumption of 20 $\mu$A, and with a load capacitance of 1 pF. A comparator in Figure 3 with the same supply voltage, with the same current consumption (inputs not in balance) and with the same load capacitance has a propagation delay of 0.5 $\mu$s.

In Figure 4, the waveform of the differential charging/discharging current as function of the differential input voltage is illustrated for both the conventional comparator of Figure 1 and the inventive comparator of Figure 3. It should be appreciated that the boosted differential output current $I_{OUT+}$- $I_{OUT-}$ is not bound to any other particular input voltage difference except 0V; the differential output current $I_{OUT+}$- $I_{OUT-}$ is boosted when the nodes $N_{G1}$ and $N_{G2}$ start to deviate from their limited voltage and the transistors $M_7$ or $M_8$ turn off. The transient starts when the input voltage crosses 0V and transient at the nodes $N_{G1}$ and $N_{G2}$ starts.

A further benefit of the inventive comparator is that the bias current of the input stage 1 is boosted only when internal nodes, i.e. the sources of the transistors $M_4$ and $M_6$, transient. The zero-crossover speed of the input voltage difference does not affect significantly on the boosting. The comparator is therefore insensitive to the input voltage step or the speed of change of the input voltage.

Since the voltage swing at the sources of the transistors $M_4$ and $M_6$ are limited to about the gate-source voltage of the transistors $M_7$ and $M_8$, the response time of the comparator is insensitive to the supply voltage variation.

Since the source voltages of the transistor $M_6$ does not go to ground (it stays approximately at the $V_{VS2}$ voltage), the actual current source for the output current $I_{OUT-}$ does not saturate. Therefore, a bipolar transistor can be used for implementing the current source of the output current $I_{OUT-}$. Same holds for the output current $I_{OUT+}$. In the comparator shown in Figure 1, a bipolar transistor would saturate, and turning it on once again from the saturation takes more time than increasing the collector voltage in linear range.

**Claims**

1. A comparator circuit, comprising
   an input stage (1) including a pair of inputs for receiving a differential input voltage and a pair of outputs for outputting a differential output current which is in relation to the differential input voltage,
   transistor output stage (2) configured to amplify the differential output current, said output stage comprising a first transistor (M1) and a second transistor (M2) having control electrodes configured to receive said differential current from the input stage (1), **characterised by**:

   first means (M7,M8) for limiting a voltage swing at said control electrodes of the transistor output stage (2) when the control electrode voltages reach respective threshold values,
   means (CM1,CCS1) configured to decrease the biasing of the input stage (1) from a normal biasing level when said first means (M7,M8) are limiting the voltage swing, to thereby decrease the differential output current, and configured to allow biasing of the input stage (1) at the normal biasing level when said first means (M7,M8) are not limiting the voltage swing.

2. A comparator circuit according to claim 1, wherein
   said transistor output stage (2) includes

   a) a first p-type transistor (M1) having a gate electrode connected to first one of the outputs of the input stage (1),
   b) a second n-type transistor (M2) having a gate electrode connected to a second one of the outputs of the input stage (1),
   c) a third p-type transistor (M3) having a source electrode connected to a first biasing voltage source (VS1), a drain electrode connected to a first current source (CS1), and a gate electrode connected to said drain electrode,
   d) a fourth p-type transistor (M4) having a source electrode connected to the gate of the first transistor (M1), a drain electrode connected to the gate of the second transistor (M2), and a gate electrode connected to the gate of the third transistor (M3),
   e) a fifth n-type transistor (M5) having a source electrode connected to a second biasing voltage source (VS2), a drain electrode connected to a second current source (CS2), and a gate electrode connected to said drain electrode,
   f) a sixth n-type electrode (M6) having a source electrode connected to the gate of the second transistor (M2), a drain electrode connected to the gate of the first transistor (M1), and a gate electrode connected to the gate of the fifth transistor (M5),
   and wherein the first means include
   g) a seventh n-transistor (M7) having a source connected to the gate of the first transistor (M1), a drain operationally connected to a first supply voltage, and a gate connected to the first biasing voltage source, and
   h) an eight p-type transistor (M8) having a source connected to the gate of the second transistor (M2), a drain operationally connected to a second supply potential, and a gate connected to the second biasing voltage source.

3. A comparator circuit according to claim 2, wherein the second means include a feedback for decreasing the biasing of the input stage (1) when a current flows via the seventh or eight transistor (M7,M8).

4. A comparator circuit according to any one of claims 1 to 3, wherein the second means include at least one current mirror (CM1).

5. A comparator circuit according to any one of claims 1 to 4, wherein the differential input stage (1) is a differential transconductance input stage.

**Patentansprüche**

1. Komparatorschaltung, umfassend
   eine Eingangsstufe (1) mit einem Paar von Eingängen, um eine differentielle Eingangsspannung zu empfangen, und einem Paar von Ausgängen, um einen differentiellen Ausgangsstrom auszugeben, der im Verhältnis zu der differentiellen Eingangsspannung ist,
   eine Transistorausgangsstufe (2), die konfiguriert ist, um den differentiellen Ausgangsstrom zu verstärken, wobei die Ausgangsstufe einen ersten Transistor (M1) und einen zweiten Transistor (M2) umfasst, die Steuerelektroden aufweisen, die konfiguriert sind, um den differentiellen Strom von der Eingangsstufe (1) zu empfangen, **gekenn-**

**zeichnet durch**:

erste Mittel (M7, M8) zum Begrenzen eines Spannungshubs an den Steuerelektroden der Transistorausgangsstufe (2), wenn die Steuerelektrodenspannungen jeweilige Schwellenwerte erreichen,

Mittel (CM1, CCS1), die konfiguriert sind, um die Vorspannung der Eingangsstufe (1) von einem normalen Vorspannungspegel zu verringern, wenn die ersten Mittel (M7, M8) den Spannungshub begrenzen, um **dadurch** den differentiellen Ausgangsstrom zu verringern, und konfiguriert sind, um eine Vorspannung der Eingangsstufe (1) bei dem normalen Vorspannungspegel zu ermöglichen, wenn die ersten Mittel (M7, M8) den Spannungshub nicht begrenzen.

2. Komparatorschaltung gemäß Anspruch 1, bei der
die Transistorausgangsstufe (2) aufweist:

a) einen ersten Transistor vom p-Typ (M1), der eine mit einem ersten der Ausgänge der Eingangsstufe (1) verbundene Gate-Elektrode aufweist,

b) einem zweiten Transistor vom n-Typ (M2), der eine mit einem zweiten der Ausgänge der Eingangsstufe (1) verbundene Gate-Elektrode aufweist,

c) einen dritten Transistor vom p-Typ (M3), der eine mit einer ersten Vorspannungs-Spannungsquelle (VS1) verbundene Source-Elektrode, eine mit einer ersten Stromquelle (CS1) verbundene Drain-Elektrode und eine mit der Drain-Elektrode verbundene Gate-Elekteode aufweist,

d) einen vierten Transistor vom p-Typ (M4), der eine mit dem Gate des ersten Transistors (M1) verbundene Source-Elektrode, eine mit dem Gate des zweiten Transistors (M2) verbundene Drain-Elektrode und eine mit dem Gate des dritten Transistors (M3) verbundene Gate-Elektrode aufweist,

e) einen fünften Transistor vom n-Typ (M5), der eine mit einer zweiten Vorspannungs-Spannungsquelle (VS2) verbundene Source-Elektrode, eine mit einer zweiten Stromquelle (CS2) verbundene Drain-Elektrode und eine mit der Drain-Elektrode verbundene Gate-Elektrode aufweist,

f) einen sechsten Transistor vom n-Typ (M6), der eine mit dem Gate des zweiten Transistors (M2) verbundene Source-Elektrode, eine mit dem Gate des ersten Transistors (M1) verbundene Drain-Elektrode und eine mit dem Gate des fünften Transistors (M5) verbundene Gate-Elektrode aufweist,

und wobei die ersten Mittel umfassen

g) einen siebten Transistor vom n-Typ (M7), der eine mit dem Gate des ersten Transistors (M1) verbundene Source, einen betriebsmäßig mit einer ersten Versorgungsspannung verbundenem Drain und ein mit der ersten Vorspannungs-Spannungsquelle verbundenes Gate aufweist, und

h) einen achten Transistor vom p-Typ (M8), der eine mit dem Gate des zweiten Transistors (M2) verbundene Source, einen betriebsmäßig mit einem zweiten Versorgungspotential verbundenen Drain und ein mit der zweiten Vorspannungs-Spannungsquelle verbundenes Gate aufweist.

3. Komparatorschaltung gemäß Anspruch 2, bei der die zweiten Mittel eine Rückkopplung zum Verringern der Vorspannung der Eingangsstufe (1) aufweisen, wenn ein Strom über den siebenten oder achten Transistor (M7, M8) fließt.

4. Komparatorschaltung gemäß einem der Ansprüche 1 bis 3, bei der die zweiten Mittel mindestens einen Stromspiegel (CM1) aufweisen.

5. Komparatorschaltung gemäß einem der Ansprüche 1 bis 4, bei der die differentielle Eingangsstufe (1) eine differentielle Transkondukranz-Eingangsstufe ist.

**Revendications**

1. Circuit comparateur, comportant
un étage d'entrée (1) incluant une paire d'entrées pour recevoir une tension d'entrée différentielle et une paire de sorties pour délivrer en sortie un courant de sortie différentiel qui est en relation avec la tension d'entrée différentielle, un étage de sortie de transistor (2) configuré pour amplifier le courant de sortie différentiel, ledit étage de sortie comportant un premier transistor (M1) et un second transistor (M2) ayant des électrodes de commande configurées pour recevoir ledit courant différentiel en provenance de l'étage d'entrée **(1), caractérisé par:**

des premiers moyens (M7, M8) pour limiter une excursion de tension au niveau desdites électrodes de commande de l'étage de sortie de transistor (2) lorsque les tensions d'électrode de commande atteignent des valeurs de seuil respectives,

des moyens (CM1, CCS1) configurés pour réduire la polarisation de l'étage d'entrée (1) à partir d'un niveau de polarisation normal lorsque lesdits premiers moyens (M7, M8) limitent l'excursion de tension, pour ainsi réduire le courant de sortie différentiel, et configurés pour permettre la polarisation de l'étage d'entrée (1) au niveau de polarisation normal lorsque lesdits premiers moyens (M7, M8) ne limitent pas l'excursion de tension.

2. Circuit comparateur selon la revendication 1, dans lequel ledit étage de sortie de transistor (2) inclut

a) un premier transistor de type p (M1) ayant une électrode de grille connectée à la première des sorties de l'étage d'entrée (1),
b) un deuxième transistor de type n (M2) ayant une électrode de grille connectée à une seconde des sorties de l'étage d'entrée (1),
c) un troisième transistor de type p (M3) ayant une électrode de source connectée à une première source de tension de polarisation (VS1), une électrode de drain connectée à une première source de courant (CS1), et une électrode de grille connectée à ladite électrode de drain,
d) un quatrième transistor de type p (M4) ayant une électrode de source connectée à la grille du premier transistor (M1), une électrode de drain connectée à la grille du deuxième transistor (M2), et une électrode de grille connectée à la grille du troisième transistor (M3),
e) un cinquième transistor de type n (M5) ayant une électrode de source connectée à un seconde source de tension de polarisation (VS2), une électrode de drain connectée à une seconde source de courant (CS2), et une électrode de grille connectée à ladite électrode de drain,
f) une sixième électrode de type n (M6) ayant une électrode de source connectée à la grille du deuxième transistor (M2), une électrode de drain connectée à la grille du premier transistor (M1), et une électrode de grille connectée à la grille du cinquième transistor (M5),
et les premiers moyens incluant
g) un septième transistor de type n (M7) ayant une source connectée à la grille du premier transistor (M1), un drain connecté de manière opérationnelle à une première tension d'alimentation, et une grille connectée à la première source de tension de polarisation, et
h) un huitième transistor de type p (M8) ayant une source connectée à la grille du deuxième transistor (M2), un drain connecté de manière de manière opérationnelle à un second potentiel d'alimentation, et une grille connectée à la seconde source de tension de polarisation.

3. Circuit comparateur selon la revendication 2, dans lequel les seconds moyens incluent une rétroaction pour réduire la polarisation de l'étage d'entrée (1) lorsqu'un courant circule via le septième ou le huitième transistor (M7, M8).

4. Circuit comparateur selon l'une quelconque des revendications 1 à 3, dans lequel les seconds moyens incluent au moins un miroir de courant (CM1).

5. Circuit comparateur selon l'une quelconque des revendications 1 à 4, dans lequel l'étage d'entrée différentiel (1) est un étage d'entrée à transconductance différentielle.

Fig. 1

CS$_{B2}$  V$_{DD}$

$\downarrow$I$_{B2}$

CS$_{B1}$

$\downarrow$I$_{B1}$

CS$_2$  V$_{DD}$

$\downarrow$I$_{CS2}$

V$_{DD}$

+

V$_{VS1}$

−

N$_{G1}$

M$_1$

V$_{INM}$  +

$\Delta$V$_{IN}$  G  +

V$_{INP}$  −  −

I$_{OUT+}$

I$_{OUT-}$

OUT

M$_3$  M$_4$

M$_5$  M$_6$

N$_{G2}$

M$_2$

1

2

VS$_2$  +

V$_{VS2}$

−

CS$_1$

$\downarrow$I$_{CS1}$

Fig. 2

I

I$_{OUT+}$  I$_{OUT-}$

$\Delta$V$_{IN}$

I$_{OUT+}$ − I$_{OUT-}$

Fig. 3

Fig. 4

$\Delta V_{IN}$

t

I

$I_{OUT+} - I_{OUT-}$
of Figure 3

$I_{OUT+} - I_{OUT-}$
of Figure 1

t